Europäisches Patentamt

European Patent Office

Office européen des brevets

(19)

(11) **EP 1 431 767 B1**

(12) **FASCICULE DE BREVET EUROPEEN**

(45) Date de publication et mention
de la délivrance du brevet:
**25.10.2006 Bulletin 2006/43**

(51) Int Cl.:
***G01R 15/16*** *(2006.01)*

(21) Numéro de dépôt: **03104761.6**

(22) Date de dépôt: **17.12.2003**

(54) **Condensateur à haute stabilité thermique pour poste blindé haute tension**

Gekapselter Hochspannungskondensator mit hoher Temperaturstabilität

High-voltage encapsulated capacitor with high temperature stability

(84) Etats contractants désignés:
**CH DE FR LI**

(30) Priorité: **20.12.2002 FR 0216268**

(43) Date de publication de la demande:
**23.06.2004 Bulletin 2004/26**

(73) Titulaire: **Areva T&D SA**
**92309 Levallois-Perret Cedex (FR)**

(72) Inventeur: **Blatter, Johannes**
**5014, Gretzenbach SO (CH)**

(74) Mandataire: **Poulin, Gérard**
**Brevatome**
**3, rue du Docteur Lancereaux**
**75008 Paris (FR)**

(56) Documents cités:
**DE-A- 2 409 595      DE-A- 19 841 164**
**US-A- 3 900 791      US-A- 5 053 915**

EP 1 431 767 B1

**Description**

L'invention concerne un condensateur à haute stabilité thermique, comportant une électrode haute tension s'étendant selon une direction longitudinale, un circuit imprimé cylindrique entourant coaxialement ladite électrode haute tension et comportant une piste électriquement conductrice formant une électrode basse tension, et un châssis définissant une surface interne cylindrique entourant coaxialement ledit circuit imprimé cylindrique, ledit circuit imprimé étant maintenu par ledit châssis.

Un tel condensateur est plus particulièrement destiné à des appareillages électriques de type blindés, c'est-à-dire avec une isolation gazeuse comme par exemple du SF6. Il est utilisé pour effectuer des mesures de la tension d'un élément à haute tension tel qu'un câble de poste blindé haute tension. L'élément à haute tension est relié électriquement à l'électrode haute tension du condensateur tandis que le châssis du condensateur est relié électriquement à la masse. Un tel ensemble est par exemple installé dans un poste de distribution électrique situé en sortie d'une centrale de production d'électricité.

L'électrode haute tension du condensateur qui est généralement constituée d'une barre métallique à section ronde, est entourée par l'électrode basse tension qui est fixée au châssis tout en étant électriquement isolée de celui-ci. Le châssis du condensateur est connecté à la masse de manière à former un pont diviseur capacitif entre l'électrode haute tension et la masse. Plus particulièrement, le pont diviseur comprend un premier condensateur constitué de l'électrode haute tension et de l'électrode basse tension, qui est monté en série avec un second condensateur constitué de l'électrode basse tension et du châssis. La tension de l'électrode basse tension est donc une image de la haute tension, et cette électrode basse tension est reliée à un dispositif de mesure.

Avec un tel agencement, les valeurs de mesure de tension sont notamment fonction de la capacité C du premier condensateur qui est donnée par la relation bien connue :

$$C = K . \frac{S}{D . \ln\left(\frac{D}{d}\right)} \qquad (1)$$

dans laquelle $K$ est une constante, $D$ et $S$ le diamètre et la surface de l'électrode basse tension, et d le diamètre de l'électrode haute tension. Ce type de condensateur est généralement placé à l'extérieur et subit des variations de température s'étendant entre - 40°C et + 80°C. Ces fluctuations provoquent des dilatations ou des contractions de ses matériaux constitutifs qui font varier sa capacité dans des proportions importantes puisque les matériaux ont leurs dimensions qui évoluent selon la relation bien connue :

$$L(T) = L_0 \left(1 + a . (T - T_0)\right) \qquad (2)$$

dans laquelle $L(T)$ désigne une longueur à la température $T$, $L_0$ cette longueur à une température de référence $T_0$, et a le coefficient de dilatation linéaire du matériau correspondant. Un accroissement de température produit une augmentation de la surface S et du diamètre D de l'électrode basse tension qui induit une variation de la capacité du condensateur, en vertu des relations (1) et (2). Les fluctuations de la température induisent ainsi des variations de la capacité qui perturbent la précision de mesure.

Dans la conception d'un tel condensateur, on cherche donc à minimiser l'influence de la température sur la capacité pour obtenir une stabilité thermique donnant une précision de mesure satisfaisante. Cette optimisation consiste généralement à concevoir une architecture mécanique particulière qui est associée à un choix de matériaux constitutifs ayant des coefficients de dilatation adaptés.

Il est connu du brevet français FR-2705492 un condensateur tel qu'indiqué plus haut dans lequel l'électrode basse tension est constituée de plusieurs plaques courbes longeant la périphérie interne du châssis, ces plaques sont fixées au châssis tout en étant libres de se dilater ou de se contracter. Dans ce condensateur connu, la variation de diamètre de l'électrode basse tension est donc conditionnée par le coefficient de dilatation du matériau constituant le châssis puisque les plaques sont fixées à celui-ci. Les variations de la surface de l'électrode basse tension sont conditionnées par le coefficient de dilatation du ou des matériaux formant les plaques. En combinant les relations (1) et (2) on montre que la stabilité thermique est satisfaisante si le rapport du coefficient de dilatation thermique du matériau constituant le châssis sur celui du matériau constituant l'électrode basse tension est compris entre un et demi et deux et demi. Ce condensateur connu a une stabilité thermique satisfaisante, mais une fabrication onéreuse du fait de la nécessité de fixer une pluralité de plaques à la périphérie interne du châssis.

Il est encore connu du brevet allemand DE-2409595, un condensateur cylindrique renfermant un circuit imprimé cylindrique ayant sa face interne revêtue d'une couche métallique pour former l'électrode basse tension. Cette construction avec un circuit imprimé cylindrique pour l'électrode basse tension est très simple et permet d'en réduire le coût de fabrication. Cependant, ce circuit imprimé cylindrique qui est libre de se dilater et de se contracter à l'intérieur du châssis sous l'effet des variations de température, rend ce condensateur trop sensible aux variations de température.

Le but de l'invention est de remédier à ces inconvénients en proposant un condensateur de construction simple présentant une stabilité thermique élevée.

A cet effet, l'invention a pour objet un condensateur à haute stabilité thermique, comportant une électrode haute tension s'étendant selon une direction longitudinale, un circuit imprimé cylindrique entourant coaxialement ladite électrode haute tension et comportant une piste électriquement conductrice formant une électrode basse tension, et un châssis définissant une surface interne cylindrique entourant coaxialement ledit circuit imprimé cylindrique, ledit circuit imprimé étant maintenu par ledit châssis, caractérisé en ce que ledit circuit imprimé est fendu le long d'une génératrice du cylindre qu'il forme, en ce que deux anneaux profilés fixés au châssis forment deux gorges circulaires se faisant face, chaque gorge recevant un bord circulaire du circuit imprimé, et en ce que lesdites gorges ont un diamètre sensiblement supérieur au diamètre de ladite surface interne cylindrique pour maintenir ledit circuit imprimé plaqué contre ladite surface interne cylindrique en cintrant les génératrices du circuit imprimé. Le circuit imprimé est ainsi plaqué à la surface en étant déformé directement par les anneaux, ce qui réduit le nombre de pièces constitutives du condensateur, tout en lui procurant une stabilité thermique et mécanique élevées. La stabilité mécanique élevée de ce condensateur le rend très peu sensible aux phénomènes de vibration et aux contraintes mécaniques qu'il peut être amené à subir durant des opérations de transport.

Avantageusement, le châssis comprend deux épaulements qui prolongent la surface interne cylindrique, chaque épaulement ayant un diamètre supérieur au diamètre de la surface interne, et chaque anneau est fixé à un épaulement correspondant. Chaque anneau est ainsi centré en étant directement fixé à un épaulement coaxial à la surface interne cylindrique, ce qui facilite le montage et réduit encore le coût de fabrication du condensateur.

Selon un mode de réalisation particulier de l'invention les bords du circuit imprimé comportent des languettes formant sensiblement des créneaux. L'effort de plaquage du circuit imprimé à la surface interne peut être diminué en réalisant des languettes de faible largeur et il peut être augmenté en réalisant des languettes de plus grande largeur.

Selon un autre mode de réalisation particulier de l'invention chaque anneau comprend une portion cylindrique s'étendant le long du circuit imprimé et à distance constante du circuit imprimé, et un câble conducteur relié à un système de mesure est soudé à une piste conductrice du circuit imprimé dans une zone située en regard de ladite portion cylindrique. Chaque portion cylindrique forme un écran qui atténue le gradient du champ électrique dans son voisinage, de sorte que le potentiel de l'électrode cylindrique est ainsi mesuré dans une zone de faible gradient, ce qui améliore la précision de mesure.

L'invention sera maintenant décrite plus en détail, et en référence aux dessins annexés qui en illustrent une forme de réalisation à titre d'exemple non limitatif.

La figure 1 est une vue en coupe du condensateur selon l'invention ;
La figure 2 est une vue en perspective du circuit imprimé cylindrique ;
La figure 3 est une vue en coupe de la fixation du circuit imprimé sur le châssis.
La figure 4 est une vue en perspective d'une variante du circuit imprimé du condensateur selon l'invention.

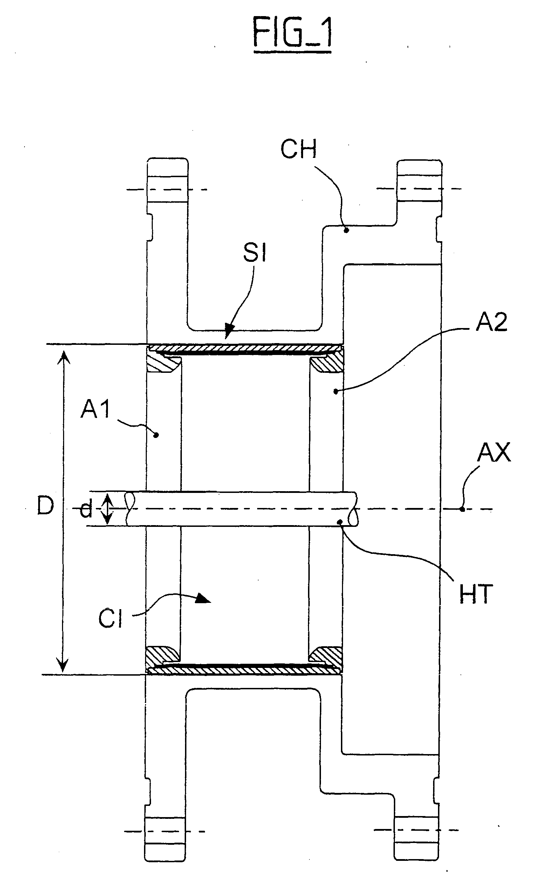

Le condensateur à haute stabilité thermique selon l'invention est un condensateur cylindrique. Il comprend une électrode haute tension HT qui s'étend selon une direction principale AX, comme représenté dans la figure 1 qui est une vue du condensateur selon un plan de coupe comprenant l'axe AX. L'électrode HT, qui est ici une barre métallique à section ronde de diamètre d, est entourée de façon coaxiale par une électrode basse tension sous la forme d'une piste électriquement conductrice d'un circuit imprimé CI cylindrique. Ce circuit imprimé est maintenu dans un châssis CH métallique destiné à être accouplé à un appareillage blindé rempli de SF6. Le châssis CH comporte une surface interne sensiblement cylindrique SI de diamètre D s'étendant coaxialement à l'axe AX et qui entoure le circuit imprimé CI pour le maintenir en position par rapport à l'électrode haute tension HT. Comme dans d'autres condensateurs connus, le châssis est connecté à la masse de manière à former un pont diviseur capacitif entre l'électrode haute tension HT et la masse, l'électrode basse tension étant reliée électriquement à un dispositif de mesure.

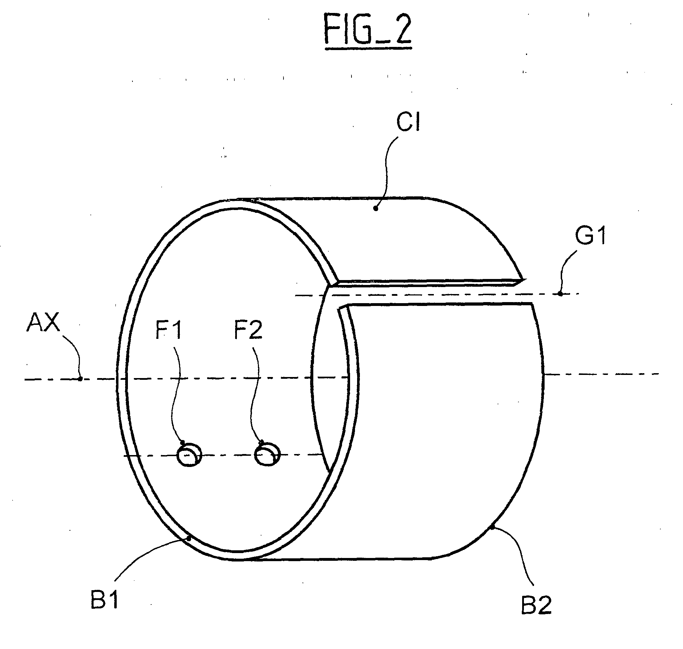

Dans le condensateur selon l'invention, le circuit imprimé CI est fendu le long d'une génératrice G1 du cylindre qu'il forme, comme représenté dans la figure 2. Plus particulièrement, ce circuit définit un cylindre qui s'étend entre deux bords circulaires B1 et B2, la fente s'étend sur toute la longueur du circuit, c'est à dire d'un bord à l'autre. Selon l'invention, les bords du circuit sont maintenus par deux anneaux profilés A1, A2 fixés au châssis CH, qui définissent deux gorges circulaires se faisant face. Chaque bord B1, B2 du circuit imprimé CI est emboîté dans une gorge, de sorte qu'il est libre de se dilater le long de la surface interne en coulissant dans ces gorges sous l'effet de variations de température. La fente du circuit imprimé CI a donc une largeur qui fluctue avec les variations de température. La variation de la surface S de l'électrode basse tension est ainsi conditionnée par le coefficient de dilatation de l'électrode basse tension, alors que la variation de son diamètre D est conditionnée par le coefficient de dilatation du châssis CH. Il en découle qu'un choix approprié des coefficients de dilatation de l'électrode basse tension et du châssis CH permet d'obtenir une stabilité thermique satisfaisante. Notamment, la stabilité thermique optimale est atteinte lorsque le coefficient de dilatation thermique du châssis vaut le double du coefficient de dilatation thermique de l'électrode basse tension comme connu de l'état de la technique mentionné précédemment. Dans l'exemple représenté sur les figures, le circuit imprimé CI est fixé au châssis CH en plusieurs points de fixation F1 et F2 répartis le long d'une génératrice G2 du cylindre que forme le circuit C, de manière à minimiser les déplacements du circuit imprimé par rapport au châssis.

Les gorges formées par les anneaux A1 et A2 ont un diamètre intérieur D1 sensiblement supérieur au diamètre D de la surface interne diminué de deux fois l'épaisseur $\varepsilon$ du circuit imprimé de sorte qu'elles exercent un effort radial important sur les bords B1, B2 du circuit imprimé CI. Ce dernier est ainsi plaqué contre au moins une zone annulaire ZCI de diamètre D de la surface interne SI, ses génératrices subissant un effet de cintrage qui se traduit par une augmentation du diamètre de ses bords. L'élasticité mécanique du circuit imprimé CI est ainsi exploitée pour lui faire jouer le rôle d'un ressort le maintenant efficacement plaqué le long de la surface interne SI. En d'autres termes, les gorges formées par les anneaux A1 et A2 contraignent les bords du circuit imprimé CI à s'évaser. Lorsque l'anneau profilé A1 est introduit à une extrémité du châssis CH pour y être fixé, le bord B1 du circuit imprimé entre en contact avec la surface de plus petit diamètre de la gorge circulaire qui est formée par cet anneau A1 et le châssis. La surface intérieure du bord B1 s'évase jusqu'à acquérir le diamètre intérieur D1 de la gorge.

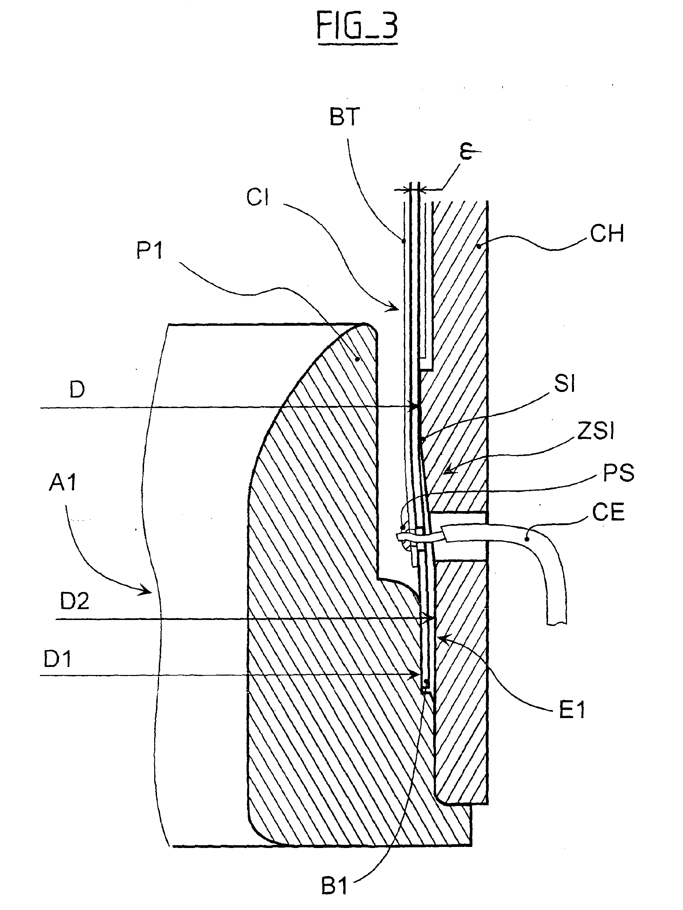

Dans le mode de réalisation représenté à la figure 3, le diamètre intérieur D1 des gorges vérifie la relation D-$\varepsilon$<D1<D. Le circuit imprimé est ainsi contraint par les gorges à avoir un diamètre plus important au niveau de ses bords qu'au niveau d'un plan de symétrie médian. Il est entendu que D1 pourrait être égal à D ou légèrement supérieur, afin de renforcer l'effet de ressort de maintien procuré par la déformation des bords du circuit, dès lors que le circuit peut supporter une telle déformation.

Dans un mode de réalisation préféré de l'invention, le châssis CH comprend deux épaulements tels que l'épaulement E1 visible figure 3. La surface cylindrique du châssis qui a un diamètre interne D, s'élargit en un épaulement annulaire E1 ayant un diamètre D2 supérieur à D, de manière à autoriser un évasement du bord B1 du circuit imprimé CI. Chaque anneau A1, A2 présente ici une section en L et est fixé à un épaulement correspondant avec lequel il définit une gorge ayant la forme d'un U. Chaque anneau A1, A2 est ainsi centré par rapport à l'axe AX en étant directement fixé à un épaulement coaxial à l'axe AX, ce qui simplifie le montage du condensateur selon l'invention. Dans ce mode de réalisation, la gorge recevant le bord du circuit imprimé est formée par l'anneau profilé A1 et la surface interne de l'épaulement E1.

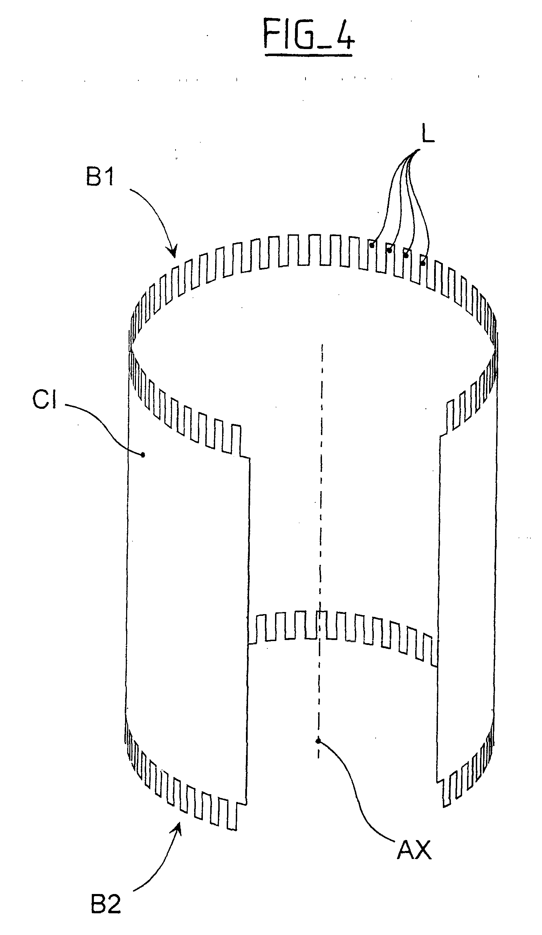

Dans un autre mode préféré de réalisation, représenté figure 4, les bords du circuit imprimé CI comprennent des languettes L qui sont destinées à atténuer l'effort de plaquage du circuit imprimé contre la surface interne SI de manière à faciliter son glissement sous l'effet de la dilatation thermique. Plus particulièrement, ces languettes définissent un crénelage et sont emboîtées dans les gorges formées par les anneaux et le châssis. En diminuant leur largeur, l'effort de plaquage est réduit, en augmentant cette largeur, l'effort de plaquage est augmenté.

Dans un autre mode de réalisation préféré du condensateur, les anneaux A1, A2 comprennent chacun une portion cylindrique telle que la portion P1 visible figure 3, s'étendant le long dudit circuit imprimé CI à distance constante de celui-ci. Un câble conducteur CE relié à un système de mesure est soudé à une piste conductrice BT du circuit imprimé CI, cette piste conductrice formant l'électrode basse tension. Plus particulièrement, le câble conducteur CE est soudé à la piste BT en un point de soudure PS qui est situé en regard de la portion cylindrique P1. Avec cet agencement, chaque portion cylindrique telle que P1 forme un écran qui atténue le gradient du champ électrique dans son voisinage, et le câble pour mesurer le potentiel de l'électrode cylindrique est ainsi placé dans une zone de faible gradient, ce qui réduit la perturbation du champ électrique et améliore la précision de mesure. Dans une alternative de réalisation des anneaux A1et A2, la portion P1 visible figure 3 peut présenter une forme non plus cylindrique mais sensiblement conique, telle que la distance entre P1 et le circuit imprimé cylindrique s'accroît dans la direction du plan médian du circuit. Une telle réalisation permet aussi de réduire la perturbation du champ électrique. Pour toutes les réalisations exposées ci-dessus, il est possible de ménager un renfoncement dans la portion P1 juste en vis à vis du point de soudure PS, de façon à augmenter la distance entre ce point et P1 pour réduire encore plus le gradient de potentiel autour de ce point.

**Revendications**

**1.**  Condensateur à haute stabilité thermique, comportant une électrode haute tension (HT) s'étendant selon une direction longitudinale (AX), un circuit imprimé (CI) cylindrique entourant coaxialement ladite électrode haute tension et comportant une piste électriquement conductrice formant une électrode basse tension (BT), et un châssis (CH) définissant une surface interne cylindrique (SI) entourant coaxialement ledit circuit imprimé cylindrique (CI), ledit circuit imprimé étant maintenu par ledit châssis (CH), ledit circuit imprimé est fendu le long d'une génératrice (G1)

**4**

du cylindre qu'il forme, **caractérisé en ce que** deux anneaux profilés (A1, A2) fixés au châssis (CH) forment deux gorges circulaires se faisant face, chaque gorge recevant un bord circulaire (B1, B2) du circuit imprimé (CI), et **en ce que** lesdites gorges ont un diamètre intérieur (D1) sensiblement supérieur au diamètre (D) de ladite surface interne cylindrique (SI) diminué de deux fois l'épaisseur (ε) du circuit imprimé pour maintenir ledit circuit imprimé (CI) plaqué contre ladite surface interne cylindrique (SI) en cintrant les génératrices du circuit imprimé (CI).

2. Condensateur selon la revendication 1, dans lequel ledit châssis (CH) comprend deux épaulements (E1) prolongeant ladite surface interne cylindrique (SI), chaque épaulement ayant un diamètre supérieur au diamètre (D) de ladite surface interne cylindrique (SI), et dans lequel chaque anneau (A1, A2) est fixé à un épaulement correspondant.

3. Condensateur selon la revendication 1 ou 2, dans lequel au moins un bord circulaire (B1, B2) dudit circuit imprimé (CI) est crénelé pour former des languettes (L).

4. Condensateur selon l'une des revendications 1 à 3, dans lequel lesdits anneaux (A1, A2) comprennent une portion cylindrique s'étendant le long dudit circuit imprimé (CI) à distance constante dudit circuit imprimé (CI), et dans lequel un câble conducteur relié à un système de mesure est soudé à une piste conductrice dudit circuit imprimé dans une zone située en regard de ladite portion cylindrique.

5. Condensateur selon l'une des revendications 1 à 4, dans lequel le diamètre intérieur D1 desdites gorges vérifie la relation D-ε<D1<D, dans laquelle D désigne le diamètre de la surface interne cylindrique (SI) du châssis et ε l'épaisseur du circuit imprimé.

## Claims

1. Capacitor with a high degree of temperature stability, the capacitor comprising a high voltage electrode (HT) extending in a longitudinal direction (AX), a cylindrical printed circuit (CI) coaxially surrounding said high voltage electrode and including an electrically conductive track which forms a low voltage electrode (BT), and a chassis (CH) defining a cylindrical inside surface (SI) coaxially surrounding said cylindrical printed circuit (CI), said printed circuit being held by said chassis (CH), said printed circuit being split along a generator line (G1) of the cylinder that it forms, **characterized in that** two shaped rings (A1, A2) fixed to the chassis (CH) form two facing circular grooves, each groove receiving a circular edge (B1, B2) of the printed circuit (CI), and **in that** said grooves are of inside diameter (D1) perceptibly greater than the diameter (D) of said cylindrical inside surface (SI) minus twice the thickness (e) of the printed circuit so as to hold said printed circuit (CI) pressed against said cylindrical inside surface (SI) by causing the generator lines of the printed circuit (CI) to bend.

2. Capacitor according to claim 1, wherein said chassis (CH) has two shoulders (E1) extending said cylindrical inside surface (SI), each shoulder having a diameter greater than the diameter (D) of said cylindrical inside surface (SI), and in which each ring (A1, A2) is fixed to a corresponding shoulder.

3. Capacitor according to claim 1 or 2, wherein at least one circular edge (B1, B2) of said printed circuit (CI) is crenellated so as to form tongues (L).

4. Capacitor according to any one of claims 1 to 3, wherein each of said rings (A1, A2) comprises a cylindrical portion extending along said printed circuit (CI) at a constant distance from said printed circuit (CI), and wherein a conductor cable connected to a measurement system is soldered to a conductive track of said printed circuit in a zone situated in register with said cylindrical portion.

5. Capacitor according to any one of claims 1 to 4, wherein the inside diameter (D1) of said grooves satisfies the relationship D-ε<D1<D, in which D designates the diameter of the cylindrical inside surface (SI) of the chassis and ε designates the thickness of the printed circuit.

## Patentansprüche

1. Kondensator mit hoher thermischer Stabilität, umfassend eine Hochspannungselektrode (HT), die sich in einer Longitudinalrichtung (AX) erstreckt, eine zylindrische gedruckte Schaltung (CI), die koaxial die Hochspannungselektrode umgibt und eine eine Niederspannungs-Elektrode (BT) bildende, elektrisch leitende Bahn umfasst, sowie ein Chassis (CH), das eine zylindrische Innenfläche (SI) festlegt, welche koaxial die zylindrische gedruckte Schaltung (CI) umgibt, wobei die gedruckte Schaltung von dem Chassis (CH) gehalten wird, die gedruckte Schaltung längs einer Mantellinie (G1) des sie bildenden Zylinders gespalten ist,

**dadurch gekennzeichnet, dass** zwei am Chassis (CH) befestigte Profilringe (A1,A2), zwei einander zugewandte kreisförmige Kehlungen bilden, wobei jede Kehlung einen kreisförmigen Rand (B1,B2) der gedruckten Schaltung (CI) aufnimmt, und **dadurch**, **dass** die Kehlungen einen Innendurchmesser (D1) aufweisen, der im wesentlichen größer ist als der Durchmesser (D) der zylindrischen Innenfläche (SI), verringert um die doppelte Dicke (ε) der gedruckten Schaltung, um die gedruckte Schaltung (CI) durch Biegung der Mantellinien der gedruckten Schaltung (CI) an der zylindrischen Innenfläche (SI) anliegen zu lassen.

2. Kondensator nach Anspruch 1, wobei das Chassis (CH) zwei Schulterelemente (E1) aufweist, welche die zylindrische Innenfläche (SI) verlängern, wobei jedes Schulterelement einen Durchmesser aufweist, der größer ist als der Durchmesser (D) der zylindrischen Innenfläche (SI), und jeder Ring (A1,A2) an einem entsprechenden Schulterelement befestigt ist.

3. Kondensator nach Anspruch 1 oder 2, wobei mindestens ein kreisförmiger Rand (B1,B2) der gedruckten Schaltung (CI) so gerändelt bzw. gezackt ist, dass er Ansatzläppchen (L) bildet.

4. Kondensator nach einem der Ansprüche 1 bis 3, wobei die Ringe (A1,A2) einen zylindrischen Teil umfassen, der sich längs der gedruckten Schaltung (CI) in konstantem Abstand von der gedruckten Schaltung (CI) erstreckt, und wobei ein mit einem Messsystem verbundenes Leiterkabel an eine Leiterbahn der gedruckten Schaltung in einer dem zylindrischen Abschnitt gegenüberliegenden Zone angeschweißt ist.

5. Kondensator nach einem der Ansprüche 1 bis 4, wobei der Innendurchmesser (G1) der Kehlungen die Beziehung $D - ε < D1 < D$ erfüllt, wobei D den Durchmesser der zylindrischen Innenfläche (SI) des Chassis und ε die Dicke der gedruckten Schaltung bezeichnet.

# FIG_1

# FIG_2

EP 1 431 767 B1

# FIG_3

9

# FIG_4